Europäisches Patentamt

European Patent Office

Office européen des brevets

(11) Veröffentlichungsnummer: **0 025 173**
**B1**

(12) **EUROPÄISCHE PATENTSCHRIFT**

(45) Veröffentlichungstag der Patentschrift: 07.05.86

(21) Anmeldenummer: 80105063.4

(22) Anmeldetag: 26.08.80

(51) Int. Cl.⁴: **H 01 L 27/10,** H 01 L 29/78, H 02 M 7/217

(54) Integrierte Gleichrichterschaltung.

(30) Priorität: 31.08.79 DE 2935292

(43) Veröffentlichungstag der Anmeldung:
18.03.81 Patentblatt 81/11

(45) Bekanntmachung des Hinweises auf die
Patenterteilung:
07.05.86 Patentblatt 86/19

(84) Benannte Vertragsstaaten:
FR GB

(56) Entgegenhaltungen:
US-A-4 158 209

IBM TECHNICAL DISCLOSURE BULLETIN,
Band 18, Nr. 12, Mai 1976, Seiten 4019-4020,
New York, USA N.G. ANANTHA et al.: "Charge
sensing circuit using charge amplification"
IEEE JOURNAL OF SOLID-STATE CIRCUITS,
Band SC-41, Nr. 1, Februar 1976, Seiten
105-108, New York, USA D.A. SEALER et al.: "A
dual differential charge-coupled analog delay
device"

(73) Patentinhaber: Siemens Aktiengesellschaft
Berlin und München Wittelsbacherplatz 2
D-8000 München 2 (DE)

(72) Erfinder: Manfred, Mauthe, Dipl.-Ing.
Mauthäuslstrasse 39
D-8000 München 70 (DE)
Erfinder: Pfleiderer, Hans-Jörg, Dr.
Franz-Krinninger-Weg 23
D-8011 Zorneding (DE)

Courier Press, Leamington Spa, England.

**Beschreibung**

In der Halbleiterschaltungstechnik ist es oftmals erforderlich, den Wechselspannungsanteil eines analogen Eingangssignals gleichzurichten, was bisher mit Hilfe von Übertragern und Halbleiterdioden durchgeführt wurde.

Die Erfindung gibt eine zur Durchführung einer solchen Aufgabe geeignete Schaltung an, deren Schaltelemente insbesondere unter Einbeziehung weiterer Schaltungsteile, die zur analogen Verarbeitung elektrischer Signale dienen, in einfacher Weise monolithisch integrierbar sind. Die Gleichrichterschaltung nach der Erfindung ist dabei durch die im kennzeichnenden Teil des Patentanspruchs 1 angegebenen Merkmale bestimmt.

Der mit der Erfindung erzielbare Vorteil besteht insbesondere darin, daß eine genaue Doppelweggleichrichtung des Wechselspannungsanteils des Eingangssignals erfolgt. Da sich die Gleichrichterschaltung nach der Erfindung ausschließlich aus Bestandteilen einer in MIS-Technologie realisierbaren Ladungsverschiebeanordnung (CTD) zusammensetzt, ist es besonders zweckmäßig, die Geleichrichterfunktion auf solchen Chips zu integrieren, die bereits CTD-Anordnungen dieser Art aufweisen, so z.B. CTD-Filter oder CTD-Bildsensoren. In diesem Fall genügt es nämlich, die eingangsseitigen Teile der CTD-Anordnungen gemäß dem Patentanspruch 1 auszubilden.

Die Erfindung wird nachfolgend anhand der Zeichnung näher erläutert. Dabei zeigt:

Fig. 1 die schmatische Darstellung eines ersten Ausführungsbeispiels,

Fig. 2 Spannungs-Zeit-Diagramme zur Erläuterung von Fig. 1 und

Fig. 3 ein zweites Ausführungsbeispiel.

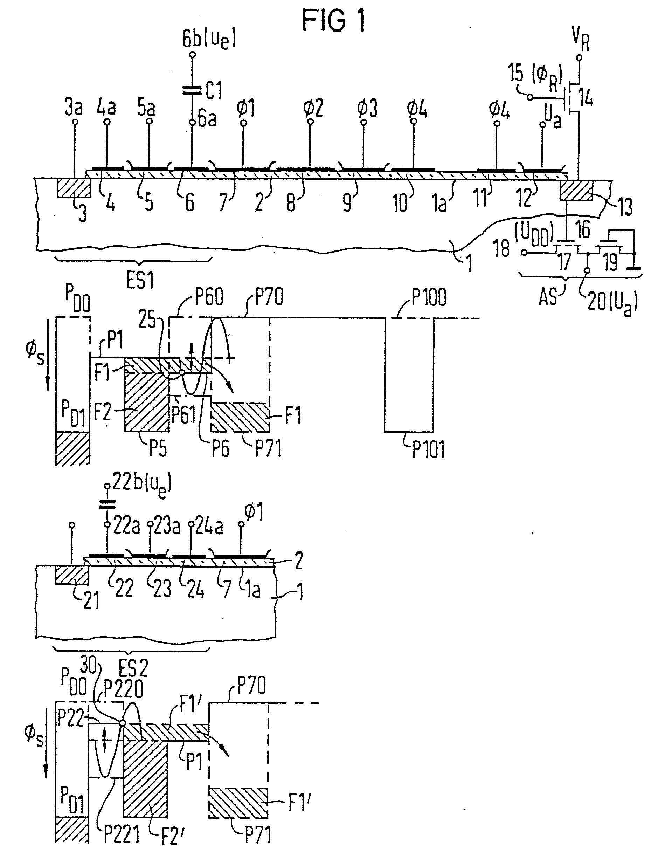

In Fig. 1 ist ein dotierter Halbleiterkörper eines vorgegebenen Leitfähigkeitstyps mit 1 bezeichnet. Er besteht beispielsweise aus p-leitendem Silizium. Seine Grenzfläche 1a ist mit einer dünnen, elektrisch isolierenden Schicht 2 bedeckt, die insbesondere aus $SiO_2$ bestehen kann und in diesem Fall als Gateoxidschicht bezeichnet wird. An der Grenzfläche 1a befindet sich ein n-leitendes Gebiet 3, das durch einen Diffusions- oder Implantationsvorgang erzeugt ist. Der neben diesem Gebiet liegende Bereich des Halbleiterkörpers 1 wird von Eingangsgateelektroden 4, 5 und 6 überdeckt, die auf der Gateoxidschicht 2 angeordnet sind. Das Gebiet 3 ist mit einem Anschluß 3a versehen, die Elektroden 4, 5 und 6 jeweils mit Anschlüssen 4a, 5a und 6a. An die Elektrode 6 schließen sich eine Reihe von Transferelektroden 7 bis 11 an, die ebenfalls auf der Gateoxidschicht 2 angeordnet sind. Jeweils vier aufeinanderfolgende Transferelektroden, z.B. 7 bis 10, sind über Anschlüsse mit jeweils einer von vier gegeneinander phasenverschobenen Taktspannungen Ø1 bis Ø4 beschaltet. Die Elektroden 7 bis 10 bezeichnen dabei eine Stufe einer CTD-Anordnung (Ladungsverschiebeanordnung). Es schließen sich weitere CTD-Stufen an, von denen in Fig. 1 nur die letzte Transferelektrode 11 der letzten Stufe dargestellt ist, die mit der Taktspannung Ø4 beschaltet ist. Der Bereich an der Oberfläche des Halbleiterkörpers 1 unterhalb der Elektroden 7 bis 11 stellt dabei den gesamten CTD-Übertragungskanal dar.

Neben der Elektrode 11 ist ein Ausgangsgate 12 vorgesehen, das mit einer Gleichspannung $U_a$ beschaltet ist. Diese Elektrode gehört zu einer CTD-Ausgangsstufe AS, die weiterhin ein zu dem Halbleiterkörper 1 entgegengesetzt dotiertes Gebiet 13 aufweist. Das Gebiet 13 ist über die Source-Drain-Strecke eines Feldeffekttransistors 14 mit einer Referenzspannung $V_R$ verbunden, wobei das Gate von 14 über einen Anschluß 15 mit einer Taktimpulsspannung $Ø_R$ beschaltet ist. Andererseits ist das Gebiet 13 mit dem Gate 16 eines Feldeffekttransistors 17 verbunden, dessen Source-Drain-Strecke einerseits über einen Anschluß 18 an eine Versorgungsspannung $U_{DD}$ und andererseits über ein Element 19 ein Bezungspotential (Masse) geschaltet ist. Das Lastelement 19 besteht in Fig. 1 aus einem Feldeffekttransistor vom Verarmungstyp, dessen Gate mit einem Sourceanschluß verbunden ist. Der Verbindungspunkt der Elemente 17 und 19 ist an den Schaltungsausgang 20 geführt.

Die Schaltungsteile 3 bis 6 bilden zusammen eine CTD-Eingangsstufe ES1. Dabei wird dem Gebiet 3 über dessen Anschluß 3a eine Taktimpulsspannung $u_d$ zugeführt, was einer herkömmlichen Betriebsweise einer solchen Eingangsstufe entspricht. Abweichend von der herkömmlichen Betriebsweise werden den Anschlüssen 4a und 6a jeweils konstante Spannungen Ue1 und Ue2 solcher Größe zugeführt, daß in den von den Elektroden 4 und 6 überdeckten Halbleiterbereichen an der Grenzfläche 1a das gleiche Oberflächenpotential $P_1$ besteht, das etwa in der Mitte des Aussteuerbereiches der Eingangsstufe ES1 liegt. Einem Anschluß 6b, der über eine Kapazität C1 mit dem Anschluß 6a verbunden ist, wird ein analoges Eingangssignal $u_e$ zugeführt. Da der Gleichspannungsanteil von $u_e$ durch C1 abgetrennt wird, gelangt lediglich der Wechselspannungsanteil $u_e'$ von $u_e$ an den Anschluß 6a. Die Elektrode 5 ist über 5a mit einer konstanten Spannung Uk1 beschaltet.

In Fig. 1 ist eine zweite Eingangsstufe ES2 unterhalb der ersten dargestellt, die ein entgegengesetzt dotiertes Gebiet 21 und Eingangsgateelektroden 22 bis 24 umfaßt. Beide Eingangsstufen ES1 und ES2 sind auf bzw. in demselben Halbleiterkörper 1 angeordnet, wobei ihre Elektroden 6 und 24 dicht neben der mit der Taktspannung Ø1 beaufschlagten Transferelektrode 7 der ersten CTD-Stufe liegen. Damit ist der CTD-Übertragungskanal beiden Eingangsstufen gemeinsam zugeordnet. Die Elektroden 22 bis 24 weisen Anschlüsse 22a bis 24a auf, von denen die Anschlüsse 22a und 24a mit konstanten Spannungen Ue3 und Ue4 solcher Größe beschaltet sind, daß auch in den unterhalb von 22 und 24 liegenden Halbleiterbereichen an der Grenzfläche 1a das bereits genannte Oberflächen-

potential P1 vorliegt. Einem Anschluß 22b wird das Eingangssignal $u_e$ zugeführt. Da 22b über eine Kapazität C2 mit dem Anschluß 22a verbunden ist, liegt an 22a lediglich der Wechselspannungsanteil $u_e'$ des Eingangssignals $u_e$ an. Der Anschluß 23a ist mit einer konstanten Spannungen Uk2 beschaltet.

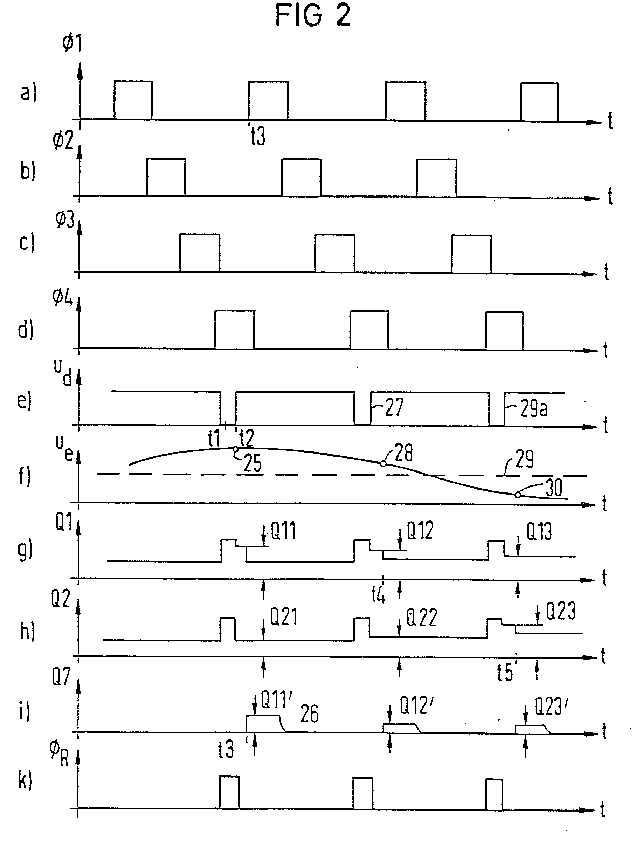

Die Wirkungsweise der Schaltung sei im folgenden anhand der Fig. 2 und der in Fig. 1 eingezeichneten Verläufe des Oberflächenpotentials $\emptyset_s$ beschrieben:

Die Spannungs-Zeit-Diagramme von Fig. 2a bis Fig. 2d zeigen dabei die Spannungsverläufe der Taktimpulsspannungen Ø1 bis Ø4. Während der Taktimpulse Ø4 wird die Spannungn $u_d$ impulsweise auf einen kleineren Wert abgesenkt (Fig. 2e). Damit ändert sich das Potential der Gebiete 3 und 21 ausgehend von dem Wert $P_{D1}$ kurzzeitig auf einen kleineren Wert $P_{D0}$. Dieser liegt beispielsweise zum Zeitpunkt t1 vor. Die Halbleiterbereiche unterhalb der Elektroden 4, 5 und 6 sowie 22, 23 und 24 werden hierbei von Ladungsträgern überschwemmt. Beim Wiederanstieg des Potentials in den Gebieten 3 und 21 (Zeitpunkt t2) fließt dann über die sich unterhalb der Elektroden 4 und 22 ergebenden Potentialschwellen ein Teil dieser Ladungsträger wieder in die Gebiete 3 und 21 zurück. Unter den Elektroden 4, 5 einerseits und 23, 24 andererseits bleiben Ladungsmengen zurück, deren Größen in Fig. 1 durch schraffierte Flächen gekennzeichnet sind. Diese Ladungsmengen hängen im einzelnen von den Potentialprofilen ab, die sich unterhalb der Eingangsgateelektroden sum Zeitpunkt t2 eingestellt haben.

Für die Eingangsstufe ES1 ergeben sich zum Zeitpunkt t2 die Potentialwerte P1 unterhalb von 4, P5 unterhalb von 5, hervorgerufen durch die konstante Spannung Uk1, und P6 unterhalb von der Elektrode 6. P6 ist einerseits abhängig von dem Potentialwert P1 und andererseits von dem sich überlagernden Potentialwert, der von dem Wechselspannungsanteil $u_e'$ des Signals $u_e$ abhängig ist. In Fig. 1 ist ein sinusförmiger Verlauf von $u_e'$ angenommen und in den Potentialverlauf $\emptyset_s$ unterhalb von 6 und 22 eingezeichnet, wobei die Linien P1 jeweils als Zeitachse verwendet werden. Zusätzlich ist der Wachselzpannungsanteil $u_e'$ in seiner zeitlichen Abhängigkeit in Fig. 2f dargestellt. Nimmt man an, daß zum Zeitpunkt t2 gerade ein Wert 25 erreicht ist, der auf der positiven Sinushalbwelle liegt, so ergibt sich unterhalb von 6 das resultierende Potential P6. Im weiteren Zeitlichen Verlauf des Eingangssignals treten unterhalb von 6 Potentialschwankungen zwischen den Grenzwerten P61 und P60 auf. Wie Fig. 1 weiter zeigt, ergeben sich zum Zeitpunkt t2 unterhalb der mit Ø1 bis Ø3 belegten Transferelektroden Potentialwerte, die einem eingezeichneten Wert P70 entsprechen, während lediglich unterhalb der Elektrode 10 und unterhalb sämtlicher anderen mit Ø4 belegten Elektroden ein Potentialwert P101 auftritt. Damit gilt für t2 das unterhalb von ES1 under unterhalb der Elektroden 7 bis 10 dargestellte Potentialprofil, das mit einer durchgehenden Linie gekennzeichnet ist.

Das unterhalb der Elektroden 5 und 6 gespeicherte Ladungspaket Q1 wird durch die schraffierten Flächen F1 und F2 dargestellt in Fig. 2g ist die zeitliche Abhängigkeit von Q1 angegeben, wobei sich zum Zeitpunkt t3 ein Wert Q11 ergibt, der den Flächen F1 und F2 in Fig. 1 entspricht. Zum Zeitpunkt t3 tritt die Anstiegsflanke eines Taktimpulses von Ø1 auf, wobei das durch F1 dargestellte Ladungspaket unter die Elektrode 7 fließt. In Fig. 2i ist der zeitliche Verlauf der unterhalb von 7 gesammelten Ladung Q7 dargestellt, wobei der Wert für t3 mit Q11' bezeichnet ist, der F1 entspricht. Beim Auftreten des nächsten Taktimpulses von Ø2 wird dann die Ladung Q7 unter die nächste Transferelektrode 8 verschoben, was durch den Ladungsabfall 26 gekennzeichnet, ist.

Bei der nächstfolgenden Ladungseingabe, die mit dem Impuls 27 der Spannung $u_d$ beginnt, wird in einer im wesentlichen analogen Weise eine Ladungsmenge Q12 unterhalb der Elektroden 5 und 6 gespeichert (Fig. 2g), die von dem Wert 28 des Wechselspannungsanteils $u_e'$ zum Zeitpunkt t4 abhängt. Aus dem in Fig. 2f eingezeichneten Nullpegel 29 des Wechselspannungsanteils ergibt sich, daß die Werte 25 und 28 auf der positiven Halbwelle von $u_e'$ liegen. Der Impuls 29a führt zwar ebenfalls zu einer Überschwemmung des Halbleiterbereiches unterhalb der Elektroden 5 und 6 mit Ladungsträgern, doch fließen diese, soweit sie nicht unterhalb von 5 verbleiben (Q13), wieder in das Gebiet 3 zurück, so daß wegen des hierbei negativen Funktionswertes 30 von $u_e'$ zum Zeitpunkt t5 aus der Stufe ES1 keine Ladungsträger unter die Elektrode 7 fließen.

Die positive Halbwelle von $u_e'$ beeinflußt andererseits das Potential $\emptyset_s$ unterhalb der Elektrode 22 in der Weise, daß sich resultierende Potentialwerte zwischen P1 und P221 ergeben. Hierbei werden in der Eingangsstufe ES2 nur Ladungen Q2 zwischengespeichert (Fig. 2h), die entweder unterhalb der Elektrode 23 verbleiben (Q21, Q22), oder wieder in das Gebiet 21 zurückfließen. Es werden also während der positiven Halbwelle von $u_e'$ keine Ladungspakete aus der Stufe ES2 in den Halbleiterbereich unterhalb von 7 eingegeben. Erst beim Auftreten der negativen Halbwelle von $u_e'$, die eine Potentialschwankung unterhalb der Elektrode 22 zwischen den Werten P1 und P220 ergibt, sammeln sich Ladungspakete in ES2, die unter die Elektrode 7 eingegeben werden. Dies sei anhand des Funktionswertes 30 von $u_e'$ erläutert, der unterhalb von der Elektrode 22 die Potentialschwelle P22 entstehen läßt.

Fig. 1 zeigt unterhalb der Stufe ES2 einen durch eine ununterbrochene Linie gekennzeichneten Verlauf des Oberflächenpotentials $\emptyset_s$, der zum Zeitpunkt 5 besteht. Die Ladung, die sich unterhalb der Elektroden 23 und 24 nach dem Ende des Impulses 29a und dem dadurch bewirkten Zurückfließen der überschüssigen Ladungsträger über die Schwelle P22 in das Gebiet 21 gesammelt haben, sind in Fig. 1 durch die Flächen F1' und F2' dargestellt und in Fig. 2h durch den Wert Q23 gekennzeichnet. Beim Auftreten des nächstfolgenden Impulses von Ø1 und der damit entstehenden Potentialsenke P71 gelangt dann das durch F1' dargestellte Ladungspaket unter die Elektrode 7, was in Fig. 2i durch den Wert Q7=Q23' angedeutet ist.

Aus Gründen der Übersichtlichkeit sind in Fig. 2 nur zwei Ladungseingaben während der positiven Halbwelle von $u_e$' beim Auftreten der Funktionswerte 25 und 28 und eine einzige Ladungseingabe während der negativen Halbwelle beim Auftreten des Funktionswertes 30 dargestellt. Bei einer integrierten Schaltung nach der Erfindung ist aber die Folgefrequenz der Spannungen $u_d$ sowie der Taktspannungen Ø1 bis Ø4 so viel höher gewählt als die Frequenz von $u_e$', daß zahlreiche Ladungseingaben während jeder positiven Halbwelle aus der Stufe ES1 und jeder negativen Halbwelle aus der Stufe ES2 erfolgen. Die eingegebenen Ladungspakete werden dann im Takt der Spannungen Ø1 bis Ø4 schrittweise unter der Reihe von Transferelektroden in Richtung auf die Ausgangsstufe AS verschoben und gelangen jeweils beim Auftreten der rückwärtigen Impulsflanken der Taktspannung Ø4 einzeln nacheinander über die unterhalb des Gate 12 gebildete Potentialschwelle in das Gebiet 13. Berücksichtigt man, daß das Gebiet 13 jeweils voher, d.h. während des Auftretens der Impulse von Ø4, über den mittels der Impulse $Ø_R$ leitend geschalteten Transistor 14 mit einer Referenzspannung $U_R$ verbunden und dann von dieser wieder abgetrennt wird, so daß es sich in einem Zustand befindet, der als "floating" bezeichnet wird, so verändert jedes in 13 eindringende Ladungspaket das Potential entsprechend der Größe des Funktionswertes von $u_e$', der der jeweiligen Ladungseingabe zugrunde lage. Aus der bisherigen Beschreibung ergibt sich, daß positive und negative Funktionswerte von $u_e$' unter der Voraussetzung gleicher absoluter Beträge gleich große Ladungspakete und damit in dem Gebiet 13 gleich große Potentialänderungen hervorrufen. Diese Potentialänderungen beeinflussen über das Gate 16 die Leitfähigkeit des Transistors 17, so daß die als Source-Folger geschaltete Transistorstufe 17, 19 an den Anschluß 20 ein Ausgangssignal $u_a$ abgibt, das aus einer Vorspannung und einer dieser überlagerten Spannung $u_e$' besteht, deren negative Halbwellen jeweils in positive Halbwellen gleichgerichtet worden sind.

Zur Erzielung eines gleichen Potentials P1 unter den Elektroden 4, 6, 22 und 24 ist es zweckmäßig, diese aus einzelnen Teilen einer ganzflächigen, leitenden Belegung zu bilden, die auf der Schicht 2 aufgebracht wird, so daß die Dicke der Schicht 2 unter ihnen möglichst konstant ist.

Die Elektroden 5 und 23 werden dann aus einzelnen Teilen einer zweiten elektrisch leitenden Belegung gebildet, die auf einer zweiten elektrisch isolierenden Schicht aufgebracht wird, welche die aus der ersten Belegung gebildeten Elektroden abdeckt. Dabei überlappen dann die Elektroden 5 und 23 mit ihren Randzonen die Elektroden 4, 6, 22 und 24 geringfügig. Bei einer solchen Ausbildung der Schaltung können die konstanten Spannungen Ue1 bis Ue4 auch durch eine einzige Spannung ersetzt werden. Das gleiche Herstellungsprinzip läßt sich ohne Schwierigkeiten auch auf die anderen Elektroden übertragen, so daß beispielsweise die Elektroden 8, 10 und 11 aus Teilen der ersten leitenden Belegung gebildet werden, die Elektroden 7, 9 und 12 aus Teilen der zweiten Belegung.

Zur Vereinfachung der Schaltung nach Fig. 1 ist es andererseits zweckmäßig, die Elektroden 5 und 23 einzusparen und dafür die Elektroden 4 und 6 und die Elektroden 22 und 24 sehr eng nebeneinander zu plazieren. Falls bei einer solchen Schaltungsausbildung Dickenschwankungen der Schicht 2 entstehen, die zu nicht mehr zu tolerierenden Abweichungen der Oberflächenpotentiale unterhalb der Elektroden 4, 6, 22 und 24 führen, kann das durch entsprechende Abstufungen der Spannungen Ue1 bis Ue4 gegeneinander ausgeglichen werden.

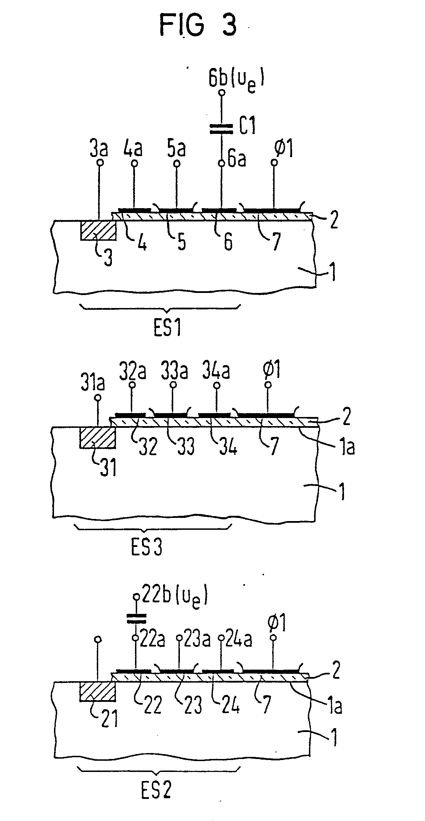

Die Fig. 3 zeigt ein zweites Ausführungsbeispiel der Erfindung, bei dem neben den bisher beschriebenen Eingangsstufen ES1 und ES2 noch eine dritte Eingangsstufe ES3 in bzw. auf dem Halbleiterkörper 1 angeordnet ist. Diese umfaßt ein entgegengesetzt zum Halbleiterkörper 1 dotiertes Gebiet 31 und auf der elektrisch isolierenden Schicht 2 angeordnete Eingangsgateelektroden 32 bis 34. An die Elektrode 34 schließt sich die erste Transferelektrode 7 der ersten CTD-Stufe an. Das Gebiet 31 ist über einen Anschluß 31a mit der Taktimpulsspannung $u_d$ belegt, während den Elektroden 32, 33 und 34 über ihre Anschlüsse 32a, 33a und 34a jeweils konstante Spannungen Ue5, Uk3 und Ue6 zugeführt werden. Dabei ist die Spannung Ue5 kleiner als Ue6 und die letztere kleiner als Uk3. Hierdurch entsteht bei jeder der bisher beschriebenen Ladungseingaben ein von der Fläche der Elektroden 33 und 34 und von der Differenz Ue6—Ue5 abhängiges Ladungspaket, das ebenfalls unter die Elektrode 7 eingegeben wird und sich als sogenannte Grundladung zu den von $u_e$' abhängigen Ladungspaketen addiert. In der englischsprachigen Literatur wird eine solche Grundladung auch als "fat zero" bezeichnet. Die in Fig. 3 dargestellte Schaltung wird noch durch die der Elektrode 7 nachgeordneten Teile, die bereits anhand von Fig. 1 beschrieben wurden, ergänzt. Auch bei der Herstellung der Stufe ES3 ist es zweckmäßig, die Elektroden 32 und 34 aus Teilen einer ersten leitenden Belegung und die Elektrode 33 aus einer zweiten leitenden Belegung zu bilden. Andererseits kann zur Vereinfachung der Schaltung die Elektrode 33 weggelassen werden, wenn die Elektroden 32 und 34 sehr nahe nebeneinander plaziert sind.

Bei der integrierten Schaltung nach der Erfindung ist es u. U. zweckmäßig die Transfergateelektrode 7 oder die Elektroden 7 und 8 mit größeren Abmessungen in Kanallängsrichtung auszuführen als die übrigen Transferelektroden 9 bis 11. Hierdurch wird ein unerwünschtes Zurückfließen von Ladungsträgern aus den mit F1 und F1' angedeuteten Ladungspaketen aus der Potentialsenke P71 in die Gebiete 3 und 21 mit großer Sicherheit vermieden.

Obwohl bischer nur von einem sinusförmigen Wechselspannungsanteil $u_e'$ ausgegangen wurde, kann die integrierte Schaltung nach der Erfindung auch auf Eingangssignale $u_e$ angewendet werden, deren Wechselspannungsanteile einen dreieckförmigen oder irgendeinen anderen, periodischen oder nichtperiodischen zeitlichen Verlauf aufweisen.

Die Eingangsgateelektroden und Transferelektroden können mit besonderem Vorteil aus hochdotiertem, polykristallinen Silizium bestehen oder, soweit sie aus der zweiten leitenden Belegung gebildet sind, aus Metall, z.B. Aluminium, gefertigt sein.

Weiterhin wurde bisher von einer CTD-Anordnung ausgegangen, die als eine SCCD-Anordnung ausgebildet ist. Hierunter versteht man eine ladungsgekoppelte Anordnung, bei der die Ladungen an der Oberfläche der Halbleiterschicht 1 verschoben werden. Darüber hinaus kann die Erfindung auch mit CTD-Anordnungen realisiert werden, bei denen ein Ladungstransport im Inneren der Halbleiterschicht 1 erfolgt und die unter der Bezeichnung "BCCD" zusammengefaßt werden. Allgemein ist bei der Erfindung jede Anordnung einsetzbar, die unter den Begriff Ladungsverschiebeanordnung (CTD) fällt, wie er beispielsweise in dem Buch von Sequin und Tompsett "Charge Transfer Devices", Academic Press, New York 1975, auf den Seiten 1 bis 18 erläutert ist. Diese Ladungsverschiebenanordnungen können dabei entsprechend ihrem Aufbau im Zwei-, Drei-, Vier- oder Mehrphasenbetrieb arbeiten. Anstelle der weiter oben beschriebenen Ausgangsstufe AS kann allgemein auch eine der in dem vorstehend genannten Buch auf den Seiten 52 bis 58 beschriebenen Ausgangsstufen verwendet werden.

**Patentansprüche**

1. Integrierte Gleichrichterschaltung, dadurch gekennzeichnet, daß an der Grenzfläche (1a) eines dotierten Halbleiterkörpers (1) ein erstes entgegengesetzt dotiertes Gebiet (3) angeordnet ist, dem ein erstes Paar von durch eine elektrische isolierende Schicht (2) von der Grenzfläche (1a) getrennten Eingangsgateelektroden (4, 6) zugeordnet ist, daß ein zweites, entgegengesetzt dotiertes Gebiet (21) vorgesehen ist, dem ein zweites Paar von Engangsgateelektroden (22, 24) zugeordnet ist, daß die Gebiete (3, 21) mit einer Taktimpulsspannung $(u_d)$ beschaltet sind, daß sämtliche Eingangsgateelektroden des ersten und des zweiten Paares mit konstanten Spannungen solcher Größe beschaltet sind, daß in den von diesen überdeckten Halbleiterbereichen das gleiche Oberflächenpotential (P1) besteht, daß die von dem ersten Gebiet (3) weiter entfernte Eingangsgateelektrode (6) des ersten Paares und die dem zweiten Gebiet (21) näher liegende Eingangsgateelektrode (22) des zweiten Paares mit dem Wechselspannungsanteil $(u_e')$ eines Eingangssignals $(u_e)$ beaufschlagt sind, daß sich an die überdeckten Halbleiterbereiche ein mit Transferelektroden (7 bis 11) überdeckter CTD-Übertragungskanal anschließt und daß eine CTD-Ausgangsstufe (AS) vorgesehen ist, die zur Auskopplung eines Signals $(u_a)$ dient, bei dem der genannte Wechselspannungsanteil $(u_e')$ gleichgerichtet ist.

2. Integrierte Gleichrichterschaltung nach Anspruch 1, dadurch gekennzeichnet, daß ein drittes entgegengesetzt dotiertes und mit der Taktimpulsspannung $(u_d)$ beschaltetes Gebiet vorgesehen ist und daß diesem ein drittes Paar von Eingangsgateelektroden zugeordnet ist, die mit festen Spannungen unterschiedlicher Größe beschaltet sind, wobei die dem dritten Gebiet näher liegende Eingangsgateelektrode des dritten Paares mit der kleineren Spannung beaufschlagt ist.

3. Integrierte Gleichrichterschaltung nach Anspruch 1 oder 2, dadurch gekennzeichnet, daß die beiden Eingangsgateelektroden (4, 6; 22, 24) eines Paares jeweils aus ein und derselben elektrisch leitenden Belegung gebildet sind und daß zwischen diesen eine dritte, aus einer zweiten elektrisch leitenden Belegung gebildete Eingangsgateelektrode (5, 23) vorgesehen ist, die mit einer konstanten, den Maximalwert des Eingangssignals übersteigenden Spannung (Uk1, Uk2, Uk3) beschaltet ist.

4. Integrierte Gleichrichterschaltung nach einem der vorhergehenden Ansprüche, dadurch gekennzeichnet, daß von den ersten beiden Transferelektroden des CTD-Übertragungskanals wenigstens die erste mit größeren Abmessungen in Kanallängsrichtung ausgeführt ist als die übrigen Transferelektroden.

5. Integrierte Gleichrichterschaltung nach einem der vorhergehenden Ansprüche, dadurch gekennzeichnet, daß die Ausgangsstufe ein impulsweise mit einem Referenzpotential verbindbares und anschließend von äußeren Potentialen abschaltbares, entgegensetzt dotiertes Gebiet aufweist, welches mit dem Steuereingang einer Transistorstufe verbunden ist.

---

**Revendications**

1. Circuit redresseur intégré, caractérisé par le fait qu'au niveau de la surface limite (1a) d'un corps semiconducteur dopé (1) se trouve disposée une première région (3) possédant un dopage de type opposé et à laquelle est associé un premier couple d'électrodes de grille d'entrée (4, 6) séparées de la surface limite (1a) par une couche électriquement isolante (2), qu'il est prévu une seconde région (21) possédant un type de dopage opposé et à laquelle est associé un second couple d'électrodes de grille d'entrée (22, 24), que les régions (3, 21) sont alimentées avec une tension impulsionnelle de cadence ($u_d$), que toutes les électrodes de grille d'entrée du premier et du second couples sont alimentées par des tensions constantes d'une amplitude telle que le même potentiel de surface (P1) est présent dans les régions semiconductrices recouvertes par ces électrodes, que l'électrode de grille d'entrée (6) du premier couple, qui est la plus éloignée de la première région (3), et l'électrode de grille d'entrée (22) du second couple, qui est la plus rapprochée de la seconde région (21), sont chargées par la composante de tension alternative ($u_e'$) d'un signal d'entrée ($u_e$), qu'un canal de transmission CTD, qui est recouvert par des électrodes de transfert (7 à 11), se raccorde aux régions semiconductrices recouvertes, et qu'il est prévu un étage de sortie CTD (AS), qui sert à découpler un signal ($u_e$) dans lequel ladite composante de tension alternative ($u_e'$) est redressée.

2. Circuit redresseur intégré suivant la revendication 1, caractérisé par le fait qu'il est prévu une troisième région dopée d'un type opposé et alimentée par la tension impulsionnelle de cadence ($u_d$), et qu'à cette région se trouve associé un troisième couple d'électrodes de grille d'entrée, qui sont alimentées par des tensions fixes possédant des amplitudes différentes, l'électrode de grille d'entrée du troisième couple, qui est la plus rapprochée de la troisième région, étant alimentée par la tension la plus faible.

3. Circuit redresseur intégré suivant la revendication 1 ou 2, caractérisé par le fait que les deux électrodes de grille d'entrée (4, 6; 22, 24) d'un couple sont formées chacune par une même couche électriquement conductrice et qu'il est prévu, entre ces électrodes, une troisième électrode de grille d'entrée (5, 23) formée par une seconde couche électriquement conductrice et qui est alimentée par une tension constante (Uk1, Uk2, Uk3) dépassant la valeur maximale du signal d'entrée.

4. Circuit redresseur intégré suivant l'une des revendications précédentes, caractérisé par le fait que parmi les deux premières électrodes de transfert du canal de transmission CTD, au moins la première est réalisée avec des dimensions, comptées suivant la direction longitudinale du canal, qui sont supérieures à celles des autres électrodes de transfert.

5. Circuit redresseur intégré suivant l'une des revendications précédentes, caractérisé par le fait que l'étage de sortie comporte une région possédant une dopage opposé, qui peut être reliée de façon impulsionnelle à un potentiel de référence et peut être ensuite déconnectée par rapport à des potentiels extérieurs et qui est reliée à l'entrée de commande d'un étage à transistors.

**Claims**

1. An integrated rectifier circuit, characterised in that there is arranged at the boundary surface (1a) of a doped semiconductor body (1) a first oppositely doped zone (3) assigned a first pair of input gate electrodes (4, 6) separated from the boundary surface (1a) by an electrically insulating layer (2), that a second oppositely doped zone (21) is provided assigned a second pair of input gate electrodes (22, 24), that the zones (3, 21) are supplied with a clock pulse voltage ($u_d$), that all the input gate electrodes of the first and second pairs are supplied with constant voltages whose magnitude is such that the same surface potential (P1) prevails in the semiconductor zones which they cover, that that input gate electrode (6) of the first pair which is further removed from the first zone (3), and that input gate electrode (22) of the second pair which is closer to the second zone (21) are supplied with the alternating voltage component ($u_e'$) of an input signal ($u_e$), that the covered semiconductor zones are adjoined by a CTD-transfer channel covered by transfer electrodes (7 to 11), and that a CTD-output stage (AS) is provided which serves to decouple a signal ($u_a$) with which the aforementioned alternating voltage component ($u_e'$) is rectified.

2. An integrated rectifier circuit as claimed in Claim 1, characterised in that a third oppositely doped zone is provided connected to the clock pulse voltage ($u_d$), and that this zone is assigned a third pair of input gate electrodes connected to fixed voltages of different magnitude, where that input gate electrode of the third pair closer to the third zone is supplied with the lower voltage.

3. An integrated rectifier circuit as claimed in Claim 1 or 2, characterised in that the two input gate electrode (4, 6; 22, 24) of a pair are formed from one and the same electrically conductive plating, and that between these there is arranged a third input gate electrode (5, 23) formed from a second electrically conductive plating and connected to a constant voltage (Uk1, Uk2, Uk3) which exceeds the maximum value of the input signal.

4. An integrated rectifier circuit as claimed in one of the preceding Claims, characterised in that at least the first of the first two transfer electrodes of the CTD-transfer channel has larger dimensions in the longitudinal direction of the channel than the other transfer electrodes.

5. An integrated rectifier circuit as claimed in one of the preceding Claims, characterised in that the output stage comprises an oppositely doped zone connected pulse-wire to a reference potential and can be disconnected from external potentials and connected to the control input of a transistor stage.

# FIG 1

# FIG 2

# FIG 3